# EUROPÄISCHE PATENTSCHRIFT

(11) **EP 1 569 263 B1**
(45) Veröffentlichungstag und Bekanntmachung des Hinweises auf die Patenterteilung: **23.11.2011**
(21) Anmeldenummer: 05002608.7
(22) Anmeldetag: 08.02.2005
(51) Int. Cl.: H01L 21/18, H01L 21/20

(54) **Verfahren zum Verbinden zweier Wafer**
Method for joining two wafers
Procédé pour coller deux plaquettes

(30) Priorität: 27.02.2004 DE 102004009625; 11.03.2004 DE 102004012013
(43) Veröffentlichungstag der Anmeldung: 31.08.2005
(73) Patentinhaber: OSRAM Opto Semiconductors GmbH, 93055 Regensburg (DE)
(72) Erfinder: Streubel, Klaus, 93164 Laaber (DE)
(74) Vertreter: Epping - Hermann - Fischer

(56) Entgegenhaltungen:
- EP-A- 0 232 935
- EP-A- 0 539 741
- EP-A- 0 758 145
- EP-A- 1 369 912
- WO-A-2004/015756
- WO-A1-02/19439
- WO-A1-03/094224
- DE-A1- 4 219 132
- DE-A1- 19 646 476
- GB-A- 2 244 374
- US-A- 5 460 318
- US-A- 5 481 082
- US-A- 5 500 540
- US-A1- 2001 014 514
- US-A1- 2002 088 979
- US-A1- 2004 033 638

## Beschreibung

Die Erfindung betrifft ein Verfahren zum Verbinden zweier Wafer.

Die Dokumente WO 02/19439 und US 2004/0033638 beschreiben durch Verbinden zweier Wafer hergestellte optoelektronische Bauelemente.

Aus der Druckschrift US 6 284 998 B1 ist ein Verfahren zum Auflöten eines elektronischen Bauelements auf ein dielektrisches Substrat bekannt. Auf einer Oberfläche des Substrats sind dazu mindestens zwei Anschlussstellen aus Metall vorgegeben, die jeweils mit Lötpaste bedeckt werden. Im Folgenden werden die Anschlüsse des elektronischen Bauelements mit den Anschlussstellen auf dem Substrat in Kontakt gebracht. Der Strahl eines Diodenlasers wird dann so lange durch die, den Anschlussstellen gegenüberliegende Seite des Substrats auf jeweils eine der metallischen Anschlussstellen gerichtet, bis die Lötpaste auf der Anschlussstelle schmilzt. Die Wellenlänge des Laserstrahls wird dabei so gewählt, dass die Laserenergie hauptsächlich von der Anschlussstelle und nicht vom dielektrischen Substrat absorbiert wird.
Nach Abkühlen der Anschlussstelle besteht eine Lötverbindung zwischen der Anschlussstelle und dem Anschluss des elektronischen Bauelements.

Die Druckschrift DE 103 03 978 A1 beschreibt ein Verfahren zur Herstellung eines Halbleiterbauelements.

Die Dokumente DE 4219132 A1 und US 2001/0014514 A1 beschreiben Verfahren zum Verbinden zweier Wafer. Die Dokumente US 5,460318, WO 2004/015756 A1 und US 5,481,082 beschreiben Verfahren zum Aufbringen einzelner optoelektronisches Bauelemente auf Träger.

Aufgabe der vorliegenden Erfindung ist es, ein Verfahren zum möglichst einfachen Verbinden zweier Wafer anzugeben.
Ferner ist es Aufgabe der Erfindung, eine Waferanordnung anzugeben.

Diese Aufgaben werden gelöst durch ein Verfahren zum Verbinden zweier Wafer nach Patentanspruch 1. Vorteilhafte Ausgestaltungen der Erfindung sind Gegenstand von Unteransprüchen.

Es wird ein Verfahren für das Verbinden zweier Wafer angegeben. Dazu wird zwischen den beiden Wafern ein Kontaktbereich gebildet, indem die beiden Wafer übereinander gelegt werden. Die Verbindung zwischen den Wafern findet durch ein örtlich und zeitlich begrenztes Erhitzen des Kontaktbereichs der beiden Wafer statt.

Örtlich begrenztes Erhitzen bedeutet in diesem Zusammenhang, dass eine nennenswerte Erwärmung der Wafer in einer Richtung parallel oder senkrecht zum Kontaktbereich, vorzugsweise in beide Richtungen, begrenzt bleibt. Nach Abkühlung sind beide Wafer dann an ihrem Kontaktbereich, am Ort der lokalen Erhitzung, mechanisch miteinander verbunden.

In einer Ausführungsform des Verfahrens werden zwei Wafer bereitgestellt. Auf wenigstens eine der Waferoberflächen wird ein Material aufgebracht. Dabei kann das Material über die gesamte Waferoberfläche verteilt aufgebracht werden, oder das Material wird stellenweise auf ausgewählte Bereiche der Waferoberfläche aufgebracht, oder das Material wird über die gesamte Waferoberfläche verteilt aufgebracht und anschließend von ausgewählten Bereichen entfernt, beispielsweise weggeätzt. Anschließend wird ein Kontaktbereich zwischen den Wafern'hergestellt, indem die Wafer so übereinandergelegt werden, dass sich das aufgebrachte Material zwischen den Wafern befindet. Durch eine lokale und zeitlich begrenzte Erhitzung des Materials im Kontaktbereich entsteht dann eine mechanische Verbindung zwischen den Wafern, vermittelt durch das Material zwischen den Wafern.

Dabei kann das Material beispielsweise geeignet so gewählt werden, dass das Material durch das lokale Erhitzen zunächst aufschmilzt und beim Abkühlen unter Ausbildung eines Eutektikums mit dem Wafer-Material erstarrt.

In einer weiteren Ausführungsform des Verfahrens werden auf die Oberflächen beider Wafer Materialien aufgebracht. Dabei unterscheidet sich das Material, das auf den ersten Wafer aufgebracht wird, vom Material, das auf den zweiten Wafer aufgebracht wird.

Die Materialien müssen dabei nicht unbedingt auf die gesamte Waferoberfläche aufgebracht werden, sondern können auch stellenweise, auf ausgewählte Bereiche der Waferoberfläche, aufgebracht werden.

Die beiden Wafer werden nachfolgend in solcher Weise übereinandergelegt, dass sich die Materialien zwischen den Wafern befinden. Die Materialien werden dann im so hergestellten Kontaktbereich zwischen den Wafern örtlich und zeitlich begrenzt erhitzt, so dass sich die beiden verschiedenen Materialen im Bereich der Erwärmung verbinden. Dies kann beispielsweise dadurch geschehen, dass die beiden Materialen aufschmelzen und sich die Materialen in der Schmelze durchmischen. Auch eine erhöhte Mobilität der Teilchen aufgrund der Erwärmung ist denkbar, so dass durch Teilchendiffusion eine Durchmischung der Materialen stattfindet.

In jedem Fall entsteht nach dem örtlich und zeitlich begrenzten Erhitzen des Kontaktbereichs eine mechanische Verbindung zwischen den Wafern, vermittelt durch die Materialien zwischen den Wafern.

In einer bevorzugten Ausführungsform der Erfindung handelt es sich bei den Materialien, die auf die Waferoberflächen am Kontaktbereich aufgebracht werden, um Lote.

In einer besonders bevorzugten Ausführungsform handelt es sich bei den Loten um Lötmetalle. Bevorzugt finden dabei die folgenden Lötmetalle im Verfahren Anwendung: Au, AuSn, Pd, In, Pt.

Beim lokalen Erhitzen des Kontaktbereichs schmelzen diese Lötmetalle auf und vermischen sich. Nach Abkühlen und Erstarren der Lotschicht besteht dann eine mechanische Verbindung zwischen den Wafern.

In einer bevorzugten Ausführungsform des Verfahrens zum Verbinden zweier Wafer wird der Kontaktbereich zwischen den Wafern mittels wenigstens eines Laserstrahls lokal erhitzt.
Für das Prinzip des Verfahrens ist es dabei unerheblich, ob ein einzelner Laserstrahl in zeitlicher Abfolge, Stelle für Stelle, oder etwa eine Vielzahl von Laserstrahlen gleichzeitig an unterschiedlichen Stellen des Kontaktbereichs zum Einsatz kommen.

Die Wellenlänge des Lasers und mindestens einer der Wafer sind dabei so aneinander angepasst, dass wenigstens einer der Wafer für den Laserstrahl zumindest teilweise durchlässig ist. Das heißt, dass allenfalls eine geringfügige Absorption der Energie des Laserstrahls im Wafer stattfindet.

Der Laserstrahl wird dann durch wenigstens einen den Wafer hindurch auf den Kontaktbereich zwischen den Wafern fokussiert.

Der Laserstrahl wird, in einer besonders bevorzugten Ausführungsform, im überwiegenden Maße von dem Material oder den Materialien am Kontaktbereich zwischen den Wafern absorbiert. Dies kann zum Beispiel dadurch geschehen, dass die Materialien am Kontaktbereich für den Laserstrahl überwiegend nicht transparent sind und die Energie des Laserstrahls absorbieren. Dadurch ist gewährleistet, dass der Kontaktbereich erhitzt wird und zwar lokal begrenzt um den Bereich herum, auf den der Fokus des Laserstrahls gerichtet ist. Die Leistung des Lasers ist dabei vorzugsweise ausreichend hoch zu wählen, so dass nach Abkühlung eine mechanische Verbindung der beiden Wafer am Kontaktbereich erfolgt ist.

In einer Ausführungsform des Verfahrens kann der Laser dabei im Dauerbetrieb betrieben werden.

Für eine bevorzugte Ausführungsform des Verfahrens ist ein Laser im gepulsten Betrieb zweckmäßig. Durch eine entsprechende Wahl von Impulsdauer und Impulsabstand kann dabei der Abtransport der an der Kontaktfläche entstehenden Wärme optimal eingestellt werden. Es kann also mit einem Laser im Pulsbetrieb die örtliche Begrenzung der Erhitzung besonders leicht erreicht werden. Auch die gewünschte zeitliche Begrenzung der Erhitzung ist bei einem pulsbetriebenen Laser durch die begrenzte Impulsdauer gegeben. Zum Erzeugen der Laserstrahlen kommt dabei in einer möglichen Ausführungsform des Verfahrens ein Nd:YAG Laser zum Einsatz.

In einer weitern Ausführungsform des beschriebenen Verfahrens wird der Laserstrahl kontinuierlich über den gesamten Kontaktbereich zwischen den wafern geführt.
Auf diese Weise werden alle Bereiche des Kontaktbereichs örtlich begrenzt erhitzt und es entsteht über den gesamten Kontaktbereich beider Wafer eine flächige, mechanische Verbindung zwischen den beiden Wafern. Die lokalen Erhitzungen des Kontaktbereichs, können dabei in zeitlicher Abfolge durch einen einzelnen Laserstrahl erfolgen oder, bei Verwendung einer Vielzahl von Laserstrahlen, an mehreren lokalen Bereichen des Kontaktbereichs gleichzeitig.

In einer anderen Ausführungsform des Verfahrens wird der Laser über ausgewählte Bereiche des Kontaktbereichs geführt, so dass nur in diesen ausgewählten Bereichen eine Verbindung zwischen den beiden Wafern hergestellt wird. Es wird dabei also eine Verbindung zwischen beiden Wafern in ausgewählten Stellen des Kontaktbereichs erreicht, während andere Bereiche des Kontaktbereichs zwischen den Wafern ohne durch direkte Erwärmung hergestellte Verbindung bleiben. Dabei können Form, Anordnung, Anzahl und Größe der Verbindungsbereiche und der verbindungsfreien Bereiche je nach den Erfordernissen des Produkts ausgebildet sein.
Das heißt, Form, Anordnung, Anzahl und Größe von Verbindungsbereichen und verbindungsfreien Bereichen können beispielsweise der erforderlichen Temperaturbeständigkeit, der bevorzugten mechanischen Stabilität, der Funktionsweise des Bauelements, oder auch den gewünschten Kosten des Produkts angepasst werden.

Auch in dieser Ausführungsform des Verfahrens ist es natürlich möglich, einen einzelnen Laserstrahl oder eine Vielzahl von Laserstrahlen einzusetzen.

In einer weitern Ausführungsform des Verfahrens erfolgt die Verbindung beider Wafer am Kontaktbereich punktweise. Dazu wird der Laserstrahl nur auf einzelne, vorgegebene Stellen des Kontaktbereichs fokussiert. An diesen Stellen kommt es dabei zu einer Verbindung zwischen den beiden Wafern. Dabei können die einzelnen Verbindungspunkte vorteilhaft an den Knotenpunkten eines regelmäßigen Netzwerks angeordnet werden. Anzahl der Verbindungspunkte und Ausgestaltung des Netzwerks können dabei an die Erfordernisse des Produkts angepasst werden.

Auch in dieser Ausführungsform ist es möglich einen Laserstrahl in zeitlicher Abfolge oder eine Vielzahl von Lasern gleichzeitig einzusetzen. Insbesondere ist es hier möglich, dass die Zahl der Laserstrahlen der Zahl der gewünschten Verbindungspunkte entspricht.

In einer besonders bevorzugten Ausführungsform des Verfahrens wird nur auf solche Bereiche des Kontaktbereichs Material aufgebracht, die danach vom Laserstrahl bestrahlt werden. Beispielsweise wird für den Fall einer punktweisen Verbindung beider Wafer nur an diesen Punkten vorher Material aufgebracht.

Bei einer Ausführungsform des beschriebenen Verfahrens enthält wenigstens einer der Wafer ein Halbleitermaterial.

In einer weitern Ausführungsform des Verfahrens zum Verbinden zweier Wafer, enthält wenigstens einer der Wafer eines der folgenden Halbleitermaterialien: Silizium, Germanium, Galliumarsenid, InP, GaP.

In einer Ausführungsform des Verfahrens enthält wenigstens einer der Wafer wenigstens eines der folgenden Metalle: Mo, Cu, CuW. Auch kann wenigstens einer der Wafer in einer weiteren Ausführungsform des Verfahrens keramische Materialen enthalten.

In einer Ausführungsform des Verfahrens umfasst wenigstens einer der Wafer eine Mehrzahl von Einzelschichten, wobei wenigstens eine der Einzelschichten eine epitaktisch aufgebrachte Schicht ist.

In einer weiteren Ausführungsform des Verfahrens enthält die epitaktisch aufgebrachte Schicht vorzugsweise eines der folgenden Halbleitermaterialen: GaInN, AlGaAs, AlGaInP, GaP, InP, InGaAs, InGaAsP, GaN, AlGaInN.

Dabei bildet in einer bevorzugten Ausführungsform des Verfahrens wenigstens eine Einzelschicht des Wafers ein elektronisches oder mikroelektronisches Bauelement.

Hierbei sind Ausführungsformen besonders bevorzugt, bei denen das elektronische Bauelement ein optoelektronisches Bauelement bildet, beispielsweise eine Leuchtdiode, einen Halbleiterlaser oder einen Detektor (z.B. Photodiode).

Weiter wird eine Waferanordnung, bei der zwei übereinanderliegende Wafer an ausgewählten Bereichen ihres Kontaktbereichs miteinander verbunden sind, beschrieben, welche nicht Teil der Erfindung ist.

Diese Verbindung kann beispielsweise durch ein Material, oder zwei verschiedene Materialen zwischen den Wafer vermittelt werden.

Der Waferanordnung liegt dabei die Idee zugrunde, dass sich die Verbindung beider Wafer nicht über den gesamten Kontaktbereich beider Wafer flächig erstreckt, sondern die beiden Wafer nur an ausgewählten Stellen ihres Kontaktbereichs miteinander verbunden sind. Dabei können die Materialen, die die Verbindung zwischen den Wafern vermitteln, entweder im gesamten Kontaktbereich aufgebracht sein, oder nur an jenen Stellen des Kontaktbereichs, an denen sich eine Verbindung zwischen den Wafern befindet.

Bei einer Ausführungsform der Waferanordnung sind die beiden Wafer an ihrem Kontaktbereich punktweise, an Verbindungspunkten, miteinander verbunden. Hierbei ist die Summe der Flächen des Kontaktbereichs, an denen die beiden Wafer miteinander verbunden sind, klein gegenüber der Summe der Flächen des Kontaktbereichs, in denen keine Verbindung zwischen den beiden Wafern besteht.

In einer bevorzugten Ausführungsform der Waferanordnung sind die Verbindungspunkte dabei an den Knoten eines regelmäßigen Netzwerks angeordnet.

In einer besonders bevorzugten Ausführungsform der beschriebenen Waferanordnung beinhaltet zumindest einer der Wafer eine besonders temperaturempfindliche Schicht. Das heißt, dass die maximale Temperatur, auf welche diese Schicht ohne Beschädigung erwärmt werden kann, kleiner ist als beispielsweise die Temperatur, bei der sich die Materialien am Kontaktbereich miteinander verbinden. In diesem Fall würde ein Erwärmen der gesamten Waferanordnung auf die Temperatur, bei der sich die Materialien verbinden, die temperaturempfindliche Schicht beschädigen.

Im folgenden werden das hier beschriebene Verfahren zum Verbinden zweier Wafer und die beschriebene Waferanordnung anhand von Ausführungsbeispielen und den dazugehörigen Figuren näher erläutert:
Figur 1 zeigt eine Prinzipskizze zum hier beschriebenen Verfahren zum Verbinden zweier Wafer anhand der Herstellung einer AlGaInP Dünnfilmleuchtdiode.
Figur 2 zeigt eine schematische Draufsicht auf den Kontaktbereich der hier beschriebenen Waferanordnung, bei der sich die Verlötung der beiden Wafer an ausgewählten Bereichen des Kontaktbereichs befindet.
Figur 3 zeigt eine Draufsicht auf den Kontaktbereich der hier beschriebenen Waferanordnung bei punktweiser Verlötung beider Wafer.

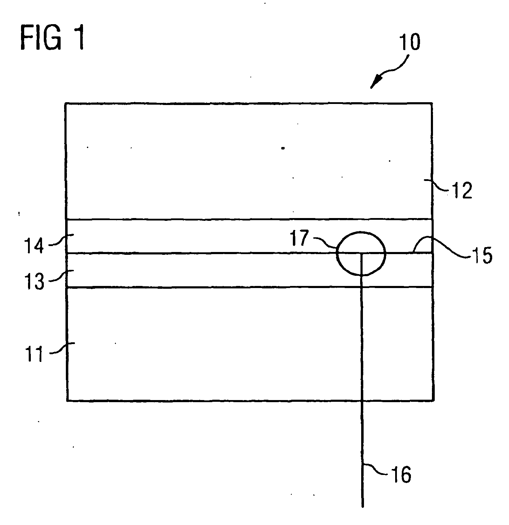

Figur 1 erläutert ein Verfahren zur Herstellung einer AlGaInP Dünnfilmleuchtdiode 10. Dazu werden beispielsweise ein GaAs Träger-Wafer 11 und eine Epitaxiescheibe 12 mit einer AlGaInP Leuchtdiodenschicht, die auf ein GaAs-Substrat epitaktisch aufgebracht ist, bereitgestellt.

Auf den Träger-Wafer 11 wird auf der Oberseite beispielsweise eine AuSn-Lotschicht 13 aufgebracht. Auf die Epitaxiescheibe 12 wird auf die Unterseite beispielsweise eine Au-Lotschicht 14 aufgebracht. Die Lotschichten 13, 14 können die Oberflächen der jeweiligen Wafer 11, 12 dabei komplett bedecken oder nur auf bestimmte Bereiche der Wafer-Oberflächen aufgebracht werden. Für das beschriebene Verfahren ist es dabei natürlich unerheblich, welches der Lötmetalle auf welchen der beiden Wafer aufgebracht wird.

Dann wird durch das Übereinanderlegen der beiden Wafer ein Kontaktbereich 15 erzeugt, so dass sich die Lötmetallschichten 13, 14 zwischen den beiden Wafern 11, 12 befinden und einander berühren.

Der Laserstrahl 16, beispielsweise eines Nd:YAG Lasers, wird daraufhin bei einer Wellenlänge durch den Träger-Wafer 11 eingestrahlt, bei welcher der Träger-Wafer 11 für den Laserstrahl 16 durchlässig ist. Dabei wird der Laserstrahl 16 auf den Kontaktbereich 15 zwischen den beiden Wafern fokussiert. Es ist darüber hinaus aber auch möglich, dass der Laserstrahl 16 durch die Epitaxiescheibe 12 hindurch auf die Kontaktschicht 15 fokussiert wird.

Die Leistung des Lasers ist dafür so gewählt, dass die beiden Lotschichten 13, 14 lokal um den Fokus des Lasers herum aufschmelzen, so dass sich die beiden Lote miteinander verbinden und nach Abkühlung und Erstarrung des lokal erhitzen Bereichs 17 eine lokale Lötverbindung zwischen den beiden Wafern 11 und 12 besteht.
Der Laser kann dabei sowohl im Dauerbetrieb, als auch gepulst betrieben werden.

Wird der Laserstrahl dabei kontinuierlich über den gesamten Kontaktbereich 15 geführt, so entsteht eine flächige Lötverbindung zwischen den beiden Wafern 11, 12.

Es versteht sich, dass neben dem genannten GaAs Wafer auch noch andere Träger-Wafer in Betracht kommen. Möglich ist beispielsweise auch die Verwendung von Wafern, die Germanium oder Silizium beinhalten. Gegebenenfalls ist dann die Wellenlänge des Laserstrahls so anzupassen, dass der Träger-Wafer für den Laserstrahl zumindest teilweise transparent ist.

Auch bei der Wahl der Epitaxiescheibe gibt es zahlreiche Möglichkeiten. So kann die Epitaxiescheibe beispielsweise eine Laserdiodenschicht oder eine Detektorschicht enthalten. Insbesondere ist das angegebene Verfahren für das Verlöten von temperaturempfindlichen Bauelementen geeignet, da die Erwärmung nicht die gesamte Waferanordnung, sondern nur einen örtlich begrenzten Bereich 17 betrifft.

Auch ist das beschriebene Verfahren hinsichtlich der Wahl der Lötmetalle nicht eingeschränkt. Da im beschriebenen Verfahren die Wärmebelastung lokal auf den Kontaktbereich zwischen den Wafern beschränkt ist, sind insbesondere Kombinationen von Lötmetallen denkbar, die sich erst bei viel höheren Temperaturen als die angegebnen Au und AuSn Lote verbinden.

Nach dem Verbinden der beiden Wafer 11, 12 kann die Waferanordnung zu einzelnen Bauelementen - beispielsweise einzelnen Leuchtdiodenchips - vereinzelt werden. Dies kann zum Beispiel mittels Sägen oder Brechen der Anordnung erfolgen. Das fertige Bauelement kann von der Seite des Träger-Wafers 11 her elektrisch kontaktiert werden. Bevorzugt sind die Lote 13, 14 dann elektrisch leitend.

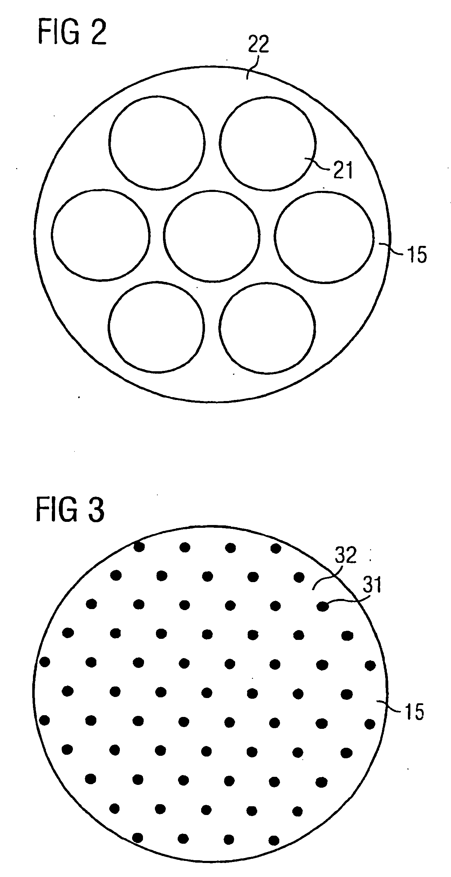

Figur 2 zeigt eine schematische Draufsicht auf den Kontaktbereich 15 zwischen zwei Wafern. Die beiden Wafer sind nur an ausgewählten Verbindungsbereichen 21 des Kontaktbereichs 15 miteinander verlötet. Neben den Verbindungsbereichen 21 finden sich auch verbindungsfreie Bereiche 22 des Kontaktbereichs 15, an denen keine Verbindung zwischen den beiden Wafern besteht.

Dabei ist es möglich, die Lötmetalle entweder nur an den Verbindungsbereichen 21 auf die Wafer aufzubringen, oder die Lötmetalle über den gesamten Kontaktbereich 15 verteilt auf den Waferoberflächen aufzubringen.

Form, Größe, Anzahl und Anordnung der ausgewählten Verbindungsbereiche 21 und der verbindungsfreien Bereiche 22 können dabei, je nach den Erfordernissen der Waferanordnung, angepasst werden.

Figur 3 zeigt eine Draufsicht auf den Kontaktbereich 15 der hier beschriebenen Waferanordnung. Dabei sind die beiden Wafer an Verbindungspunkten 31 des Kontaktbereichs 15 miteinander verbunden. Die Verbindungspunkte 31 sind dabei an den Knoten eines regelmäßigen Netzwerks angeordnet. Der verbindungsfreie Bereich 32 nimmt dabei eine weitaus größere Fläche des Kontaktbereichs 15 ein, als die Gesamtfläche der Verbindungspunkte 31 beträgt.

Dabei ist es möglich die Lötmetalle entweder nur an den Verbindungspunkten 31 auf die Wafer aufzubringen, oder die Lötmetalle über den gesamten Kontaktbereich 15 auf den Waferoberflächen aufzubringen.

Anzahl und Anordnung der Verbindungspunkte 31 werden dabei an die Erfordernisse der Waferanordnung und die Anforderungen an das herzustellende Bauelement angepasst. Nach dem Vereinzeln der Waferanordung können in diesem Ausführungsbeispiel Bauelemente resultieren, die von der Seite des Träger-Wafers 11 her nur punktweise elektrisch kontaktiert sind.

Da bei einer punktweisen Verbindung beider Wafer, die Temperaturbelastung besonders gering ist, ist diese Waferanordnung beispielsweise dann besonders geeignet, wenn zumindest einer der Wafer ein temperaturempfindliches Bauteil beinhaltet. Denn bei punktweisen Verbinden der beiden Wafer findet nur an wenigen Stellen der Waferanordnung ein geringer Temperatureintrag in die Wafer statt und der insgesamte Temperatureintrag ist dabei sehr gering.

Auch ist es in den beiden letztgenannten Ausführungsbeispielen möglich, dass pro Verbindungspunkt 31 oder pro Verbindungsbereich 21 genau ein Bauelement resultiert. Das heißt, es ist möglich, dass beispielsweise Stellen, an denen die Waferanordnung vereinzelt werden soll (beispielsweise Sollbruchstellen oder Sägekanäle), die Wafer 11, 12 nicht miteinander verbunden werden. Nur dort, wo Bauelemente entstehen sollen, findet dann ein Verbinden der beiden Wafer 11, 12 statt.

## Patentansprüche

1. Verfahren zur Herstellung optoelektronischer Bauelemente,
bei dem durch Übereinanderlegen von zwei Wafern (11,12) ein Kontaktbereich (15) zwischen den Wafern (11,12) gebildet wird und bei dem der Kontaktbereich (15) örtlich und zeitlich begrenzt erhitzt wird, wobei
- wenigstens einer der Wafer (11,12) eine Mehrzahl von Einzelschichten umfasst,
- wenigstens eine der Mehrzahl von Einzelschichten des Wafers Teil eines optoelektronischen Bauelements ist, und
- nach dem Verbinden der beiden Wafer (11, 12) die Anordnung der Wafer zu einzelnen optoelektronischen Bauelementen vereinzelt wird.

2. Verfahren nach Anspruch 1,
mit folgenden Schritten:
a) Bereitstellen von zwei Wafern (11,12),
b) zumindest stellenweises Aufbringen von Material (13,14) auf wenigstens eine der Waferoberflächen,
c) Bilden eines Kontaktbereichs (15) zwischen den Wafern (11,12) durch Übereinanderlegen der Wafer (11,12), so dass sich das Material (13,14) zwischen den Wafern (11,12) befindet.

3. Verfahren nach Anspruch 2,
bei dem das Material (13,14) so beschaffen ist, dass nach Erhitzen und Abkühlen des Materials (13,14) eine mechanische Verbindung zwischen den Wafern (11,12) hergestellt ist.

4. Verfahren nach Anspruch 2,
bei dem nach Erhitzen und Abkühlen des Materials (13,14) eine Legierung des Materials (13,14) mit wenigstens einem der Wafer (11,12) besteht.

5. Verfahren nach einem der Ansprüche 1 oder 2,
bei dem Materialien (13,14) auf beide Wafer (11,12) aufgebracht werden, wobei sich das Material (13), das auf den ersten Wafer aufgebracht wird, vom Material (14), das auf den zweiten Wafer aufgebracht wird, unterscheidet.

6. Verfahren nach Anspruch 5,
bei dem sich die unterschiedlichen Materialien (13,14) bei Erwärmung durchmischen und nach Abkühlung eine mechanische Verbindung zwischen den Wafern (11,12) herstellen.

7. Verfahren nach einem der Ansprüche 2 bis 6,
bei dem es sich bei den Materialien (13,14) um Lote handelt.

8. Verfahren nach Anspruch 7,
bei dem die Lote aus den folgenden Materialien (13,14) ausgewählt werden: Au, AuSn, Pd, In, Pt.

9. Verfahren nach einem der Ansprüche 1 bis 8,
bei dem die lokale Erhitzung des Kontaktbereichs mittels wenigstens eines Laserstrahls (16) vorgenommen wird.

10. Verfahren nach Anspruch 9,
bei dem die Wellenlänge des Laserstrahls (16) und wenigstens einer der Wafer (11,12) so aneinander angepasst sind, dass der Wafer (11,12) für den Laser zumindest teilweise durchlässig ist.

11. Verfahren nach einem der Ansprüche 9 oder 10,
bei dem der Laserstrahl (16) durch wenigstens einen der Wafer (11,12) hindurch läuft und auf den Kontaktbereich (15) fokussiert wird.

12. Verfahren nach einem der Ansprüche 9 bis 11,
bei dem die Leistung des Lasers so gewählt wird, dass am Kontaktbereich (15) eine mechanische Verbindung zwischen den beiden Wafern entsteht.

13. Verfahren nach einem der Ansprüche 9 bis 12,
bei dem der Laser im Dauerbetrieb betrieben wird.

14. Verfahren nach einem der Ansprüche 9 bis 12,
bei dem der Laser im Pulsbetrieb betrieben wird.

15. Verfahren nach einem der Ansprüche 9 bis 14,
bei dem als Laser ein Nd:YAG Laser zum Einsatz kommt.

16. Verfahren nach einem der Ansprüche 1 bis 15,
bei dem der Laserstrahl (16) kontinuierlich über den gesamten Kontaktbereich (15) geführt wird.

17. Verfahren nach einem der Ansprüche 1 bis 15,
bei dem der Laserstrahl (16) über ausgewählte Bereiche des Kontaktbereichs (15) geführt wird.

18. Verfahren nach Anspruch 17,
bei dem der Laserstrahl (16) punktweise auf Bereiche des Kontaktbereichs (15) fokussiert wird, so dass Verbindungspunkte (31) zwischen den Wafern entstehen.

19. Verfahren nach Anspruch 18,
bei dem die Verbindungspunkte (31) an den Knoten eines regelmäßigen Netzwerks angeordnet werden.

20. Verfahren nach einem der Ansprüche 18 oder 19,
bei dem die Zahl der Laserstrahlen (16) der Zahl der Verbindungspunkte (31) entspricht.

21. Verfahren nach einem der Ansprüche 17 bis 20,
bei dem nur an den Bereichen des Kontaktbereichs (15) ein Material aufgebracht ist, die vom Laserstrahl (16) bestrahlt werden.

22. Verfahren nach einem der Ansprüche 1 bis 21,
bei dem wenigstens einer der Wafer (11,12) wenigstens ein Halbleitermaterial enthält.

23. Verfahren nach Anspruch 22,
bei dem wenigstens einer der Wafer (11,12) mindestens eines der folgenden Halbleitermaterialien enthält: Silizium, Germanium, Galliumarsenid, InP, GaP.

24. Verfahren nach Anspruch 1,
bei dem wenigstens eine der Einzelschichten eine epitaktisch aufgebrachte Schicht ist.

25. Verfahren nach Anspruch 24,
bei dem die epitaktisch aufgebrachte Schicht wenigstens eines der folgenden Halbleitermaterialien enthält: GaInN, AlGaAs, AlGaInP, GaP, InP, InGaAs, InGaAsP, GaN, AlGaInN.

26. Verfahren nach Anspruch 1,
bei dem das optoelektronische Bauelement eine Leuchtdiode ist.

27. Verfahren nach Anspruch 1,
bei dem das optoelektronische Bauelement ein Halbleiterlaser ist.

28. Verfahren nach Anspruch 1,
bei dem das optoelektronische Bauelement ein Detektor ist.

## Claims

1. Method for the production of optoelectronic components, in which a contact area (15) is formed between two wafers (11, 12) by placing the wafers (11, 12) one on top of the other, and in which the contact area (15) is heated locally and for a limited time, wherein
- at least one of the wafers (11, 12) has two or more individual layers,
- at least one of the plurality of individual layers of the wafer is part of an optoelectronic component, and
- after the connection of the two wafers (11, 12) the arrangement of the wafers is separated into individual optoelectronic components.

2. The method according to Claim 1,
having the following steps:
a) provision of two wafers (11, 12),
b) application of material (13, 14) at least in places to at least one of the wafer surfaces,
c) formation of a contact area (15) between the wafers (11, 12) by placing the wafers (11, 12) one on top of the other, so that the material (13, 14) is located between the wafers (11, 12).

3. The method according to Claim 2,
in which the material (13, 14) is of such a type that a mechanical joint is produced between the wafers (11, 12) once the material (13, 14) has been heated and cooled down.

4. The method according to Claim 2,
in which an alloy of the material (13, 14) with at least one of the wafers (11, 12) is produced after the material (13, 14) has been heated and cooled down.

5. The method according to one of Claims 1 or 2,
in which materials (13, 14) are applied to both wafers (11, 12), with the material (13) which is applied to the first wafer not being the same as the material (14) which is applied to the second wafer.

6. The method according to Claim 5,
in which the different materials (13, 14) mix during heating and produce a mechanical joint between the wafers (11, 12) after they have cooled down.

7. The method according to one of Claims 2 to 6,
in which the materials (13, 14) are solders.

8. The method according to Claim 7,
in which the solders are selected from the following materials (13, 14): Au, AuSn, Pd, In, Pt.

9. The method according to one of Claims 1 to 8,
in which the contact area is heated locally by means of at least one laser beam (16).

10. The method according to Claim 9,
in which the wavelength of the laser beam (16) and at least one of the wafers (11, 12) are matched to one another such that the laser can pass at least partially through the wafer (11, 12).

11. The method according to one of Claims 9 or 10,
in which the laser beam (16) passes through at least one of the wafers (11, 12) and is focused on the contact area (15).

12. The method according to one of Claims 9 to 11,
in which the power of the laser is selected so as to produce a mechanical joint between the two wafers in the contact area (15).

13. The method according to one of Claims 9 to 12,
in which the laser is operated in the continuous mode.

14. The method according to one of Claims 9 to 12,
in which the laser is operated in the pulsed mode.

15. The method according to one of Claims 9 to 14,
in which an Nd:YAG laser is used as the laser.

16. The method according to one of Claims 1 to 15,
in which the laser beam (16) is passed continuously over the entire contact area (15).

17. The method according to one of Claims 1 to 15,
in which the laser beam (16) is passed over selected areas of the contact area (15).

18. The method according to Claim 17,
in which the laser beam (16) is focused at points on areas of the contact area (15) so that junction points (31) are created between the wafers.

19. The method according to Claim 18,
in which the junction points (31) are arranged at the nodes of a regular network.

20. The method according to one of Claims 18 or 19,
in which the number of laser beams (16) corresponds to the number of junction points (31).

21. The method according to one of Claims 17 to 20,
in which a material is applied only to the areas of the contact area (15) and is illuminated by the laser beam (16).

22. The method according to one of Claims 1 to 21,
in which at least one of the wafers (11, 12) contains at least one semiconductor material.

23. The method according to Claim 22,
in which at least one of the wafers (11, 12) contains at least one of the following semiconductor materials: silicon, germanium, gallium arsenide, InP, GaP.

24. The method according to Claim 1,
in which at least one of the individual layers is an epitaxially applied layer.

25. The method according to Claim 24,
in which the epitaxially applied layer contains at least one of the following semiconductor materials: GaInN, AlGaAs, AlGaInP, GaP, InP, InGaAs, InGaAsP, GaN, AlGaInN.

26. The method according to Claim 1,
in which the optoelectronic component is a light-emitting diode.

27. The method according to Claim 1,
in which the optoelectronic component is a semiconductor laser.

28. The method according to Claim 1,
in which the optoelectronic component is a detector.

## Revendications

1. Procédé de fabrication de composants optoélectroniques, dans lequel la superposition de deux plaquettes (11, 12) forme une zone de contact (15) entre les plaquettes (11, 12) et dans lequel la zone de contact (15) est chauffée de manière limitée localement et temporellement, dans lequel
- au moins une des plaquettes (11, 12) comporte plusieurs couches individuelles,
- au moins une des couches individuelles de la plaquette est une partie d'un composant optoélectronique, et
- après liaison des deux plaquettes (11, 12), l'arrangement des plaquettes est dissocié en composants optoélectroniques individuels.

2. Procédé selon la revendication 1, avec les étapes suivantes :
a) préparation de deux plaquettes (11, 12),
b) dépôt de matériau (13, 14) au moins par endroits sur au moins une des surfaces de plaquettes,
c) formation d'une zone de contact (15) entre les plaquettes (11, 12) par superposition des plaquettes (11, 12) de telle sorte que le matériau (13, 14) se trouve entre les plaquettes (11, 12).

3. Procédé selon la revendication 2, dans lequel le matériau (13, 14) est de nature à établir une liaison mécanique entre les plaquettes (11, 12) après échauffement et refroidissement du matériau (13, 14).

4. Procédé selon la revendication 2, dans lequel après échauffement et refroidissement du matériau (13, 14), il existe un alliage du matériau (13, 14) avec au moins une des plaquettes (11, 12).

5. Procédé selon une des revendications 1 ou 2, dans lequel on dépose des matériaux (13, 14) sur les deux plaquettes (11, 12), le matériau (13) déposé sur la première plaquette se distinguant du matériau (14) déposé sur la deuxième plaquette.

6. Procédé selon la revendication 5, dans lequel les différents matériaux (13, 14) se mélangent lors du chauffage et établissent après refroidissement une liaison mécanique entre les plaquettes (11, 12).

7. Procédé selon une des revendications 2 à 6, dans lequel il s'agit de brasure en ce qui concerne les matériaux (13, 14).

8. Procédé selon la revendication 7, dans lequel les brasures sont choisies parmi les matériaux (13, 14) suivants : Au, AuSn, Pd, In, Pt.

9. Procédé selon une des revendications 1 à 8, dans lequel le chauffage local de la zone de contact est effectué au moyen d'au moins un faisceau laser (16).

10. Procédé selon la revendication 9, dans lequel la longueur d'onde du faisceau laser (16) et au moins une des plaquettes (11, 12) sont adaptées l'une à l'autre de telle sorte que la plaquette (11, 12) soit au moins partiellement transparente pour le laser.

11. Procédé selon une des revendications 9 ou 10, dans lequel le faisceau laser (16) traverse au moins une des plaquettes (11, 12) et est focalisé sur la zone de contact (15).

12. Procédé selon une des revendications 9 à 11, dans lequel la puissance du laser est choisie de manière à former dans la zone de contact (15), une liaison mécanique entre les deux plaquettes.

13. Procédé selon une des revendications 9 à 12, dans lequel le laser est utilisé en régime continu.

14. Procédé selon une des revendications 9 à 12, dans lequel le laser est utilisé en régime pulsé.

15. Procédé selon une des revendications 9 à 14, dans lequel le laser utilisé est un laser Nd:YAG.

16. Procédé selon une des revendications 1 à 15, dans lequel le faisceau laser (16) est dirigé en continu sur l'ensemble de la zone de contact (15).

17. Procédé selon une des revendications 1 à 15, dans lequel le faisceau laser (16) est dirigé sur des zones sélectionnées de la zone de contact (15).

18. Procédé selon la revendication 17, dans lequel le faisceau laser (16) est focalisé ponctuellement sur des zones de la zone de contact (15) de manière à former des points de liaison (31) entre les plaquettes.

19. Procédé selon la revendication 18, dans lequel les points de liaison (31) sont disposés aux noeuds d'un réseau régulier.

20. Procédé selon une des revendications 18 ou 19, dans lequel le nombre de faisceaux laser (16) correspond au nombre de points de liaison (31).

21. Procédé selon une des revendications 17 à 20, dans lequel on dépose un matériau uniquement sur les zones de la zone de contact (15) qui sont insolées par le faisceau laser (16).

22. Procédé selon une des revendications 1 à 21, dans lequel au moins une des plaquettes (11, 12) contient au moins un matériau semi-conducteur.

23. Procédé selon la revendication 22, dans lequel au moins une des plaquettes (11, 12) contient au moins un des matériaux semi-conducteurs suivants : silicium, germanium, arséniure de gallium, InP, GaP.

24. Procédé selon la revendication 1, dans lequel au moins une des couches individuelles est une couche déposée par épitaxie.

25. Procédé selon la revendication 24, dans lequel la couche déposée par épitaxie contient au moins un des matériaux semi-conducteurs suivants : GaInN, AlGaAs, AlGaInP, GaP, InP, InGaAs, InGaAsP, GaN, AlGaInN.

26. Procédé selon la revendication 1, dans lequel le composant optoélectronique est une diode luminescente.

27. Procédé selon la revendication 1, dans lequel le composant optoélectronique est un laser semi-conducteur.

28. Procédé selon la revendication 1, dans lequel le composant optoélectronique est un détecteur.
